# EUROPÄISCHE PATENTANMELDUNG

(11) **EP 4 529 366 A1**
(43) Veröffentlichungstag der Anmeldung: **26.03.2025**
(21) Anmeldenummer: 24189851.9
(22) Anmeldetag: 19.07.2024
(51) Int. Cl.: H05K 1/02, H05K 1/16, H01R 24/64, H01R 13/66

(54) **ELEKTRISCHER VERBINDER FÜR EIN DATENKABEL**

(30) Priorität: 21.09.2023 DE 102023125696
(71) Anmelder: METZ CONNECT TECH GmbH, 78176 Blumberg (DE)
(72) Erfinder: Pyczak, Andreas, 78547 Hilzingen (DE); Merk, Benjamin, 78176 Blumberg (DE); Hettich, Klaus, 78176 Blumberg (DE)
(74) Vertreter: Westphal, Mussgnug & Partner Patentanwälte mbB

(57) **Zusammenfassung**

Elektrischer Verbinder für ein Datenkabel mit folgenden Merkmalen:
- ein Gehäuse (10),
- eine zumindest teilweise im Gehäuse (10) angeordneten Leiterplatte (20), wobei die Leiterplatte (20) als mehrlagige Leiterplatte ausgebildet ist.
- erste Kontaktelemente (30) und zweite Kontaktelemente (35), wobei diese über eine Leiterbahn (21) miteinander verbunden sind, wobei die Leiterbahn (21) einen Leitungspfad (25) und Kontaktpads (117, 118) aufweist.
gekennzeichnet durch die weiteren Merkmale:
- die Leiterplatte (20) bildet Leitflächen (40) aus, wobei jede Leitfläche (40) von anderen leitenden Flächen elektrisch isoliert ist,
- die Leitflächen (40) sind auf den inneren Leiterplattenlagen (26) angeordnet,
- eine innere Leiterplattenlage (26) weist mindestens drei Leitflächen (40) auf, und
- die Leitfläche (40) ist höchstens zu einem Leitungspfad (25) überlappend angeordnet.

## Beschreibung

Die Erfindung betrifft einen elektrischen Verbinder für ein Datenkabel gemäß den Merkmalen des Anspruchs 1.

Bei elektrischen Verbindern, insbesondere im Bereich der Hochfrequenztechnik, weisen Leiterplatten floatende Masseflächen auf, wobei die Masseflächen sich über nahezu die gesamte Leiterplattenlage erstrecken. Diese Masseflächen sollen insbesondere das EMV-Verhalten verbessern, Crosstalk reduzieren oder die Impedanzen von Leitungen oder Bauteilen beeinflussen. Ein elektrischer Verbinder, welcher eine Leiterplatte mit Massefläche aufweist, um das EMV-Verhalten zu verbessern, Crosstalk zu reduzieren oder die Impedanzen von Leitungen oder Bauteilen zu beeinflussen, ist aus US 89 15 756 B2 bekannt.

Zusätzlich zu den genannten Vorteilen hat eine Massefläche einen positiven Effekt auf die Stabilisation des Lagenaufbaus einer Leiterplatte. Um diese zu verbessern und gleichzeitig das Schaltungsdesign einer bestehenden Schaltung beizubehalten, dürfen die Masseflächen kaum bis keinen Einfluss auf die bestehende Schaltung aufweisen.

Dieses Problem wird durch einen elektrischen Verbinder mit den Merkmalen des Patentanspruchs 1 gelöst.

Vorteilhafte Ausgestaltungen und Weiterbildungen der Erfindung sind in den abhängigen Ansprüchen angegeben.

Erfindungsgemäß ist demnach ein elektrischer Verbinder für ein Datenkabel mit einem Gehäuse und eine zumindest teilweise im Gehäuse angeordnete Leiterplatte, wobei die Leiterplatte als mehrlagige Leiterplatte ausgebildet ist. An der Leiterplatte sind erste Kontaktelemente und zweite Kontaktelemente angeordnet, wobei diese jeweils über eine Leiterbahn miteinander verbunden sind. Eine Leiterbahn weist einen Leitungspfad und Kontaktpads auf. Die Leiterplatte weist elektrisch isolierte Leitflächen auf. Die Leitflächen sind dabei auf mindestens einer inneren Leiterplattenlage angeordnet, wobei eine innere Leiterplattenlage mindestens drei Leitflächen aufweist und die Leitfläche höchstens zu einem Leitungspfad überlappend angeordnet ist.

Die Leitflächen sind inselförmig und elektrisch isoliert auf der Leiterplatte angeordnet. Inselförmig meint dabei, dass die Leitfläche mit keiner anderen leitenden Fläche verbunden ist. Leitende Flächen können dabei andere Leitflächen, Leiterbahnen, Stichleitungen, Kompensationseinheiten und weitere sein. Eine Überlappung der Leitfläche mit dem signalführenden Leitungspfad und/oder den Kontaktpads verändert unter Umständen einige Parameter im verwendeten Schaltungsdesign. Um eine Stabilisierung des Lagenaufbaus zu erreichen, ohne einige Parameter zu verändern, werden Leitflächen derart auf den inneren Leiterplattenlagen der Leiterplatte angeordnet, sodass die Leitflächen groß genug sind, um eine stabilisierende Wirkung zu erzeugen, jedoch klein genug sind, sodass die Leitfläche nicht mit mehr als einem Leitungspfad überlappend angeordnet ist. Würde eine Leitfläche mehr als einen Leitungspfad überlappen, so wäre der Einfluss der Leitfläche auf die Hochfrequenzübertragungsparameter zu groß und das Schaltungsdesign müsste abgeändert werden, was wiederrum den Entwicklungsaufwand und damit die Kosten erhöht.

Vorteilhafterweise bilden jeweils zwei Leiterbahnen eine differentielle Leitung aus, wobei eine Leiterbahn ein erstes und zweites Kontaktpad aufweist, welche über einen Leitungspfad miteinander verbunden sind.

Die Kontaktelemente sind in erste und zweite Kontaktelemente unterteilbar, wobei die ersten Kontaktelemente vorzugsweise als Schneidklemmen und die zweiten Kontaktelemente als Steckkontakte ausgebildet sind. Die Kontaktpads sind ebenfalls in erste und zweite Kontaktpads unterteilbar, wobei die ersten Kontaktelemente direkt mit den ersten Kontaktpads verbunden sind, und wobei die zweiten Kontaktelemente direkt mit den zweiten Kontaktpads verbunden sind. Die ersten und zweiten Kontaktpads sind um erste und zweite Durchgangsöffnungen herum ausgebildet. Ein Kontaktpad kann auf mehreren Leiterplattenlagen ausgebildet sein. Die Durchgangsöffnungen sind an den Rändern verkupfert, wobei diese verkupferten Ränder die einzelnen Ebenen des Kontaktpads miteinander verbinden, und Teil eines Kontaktpads sind. Die Kontaktpads können die Form eines Kreises, eines Ovals, eines Vierecks aufweisen.

Die ersten Kontaktelemente sind als Schneidklemmen ausgebildet. Schneidklemmen, welche auch IDC genannt werden, zeichnen sich dadurch aus, dass eine schnelle und einfache Installation bewerkstelligbar ist. Die Drähte können mithilfe der Schneidklemmen elektrisch kontaktiert werden, ohne dass die Isolation gesondert entfernt werden muss, wodurch Zeit und die Fehleranfälligkeit sinken. Zudem werden keine speziellen Werkzeuge zur Abisolierung der Drähte benötigt. Schneidklemmen zeichnen sich durch eine äußerst zuverlässige Verbindung aus. Beim Zusammensetzten durchschneiden die Klemmen der Schneidklemme die Isolierung, wodurch eine gasdichte Verbindung zwischen Draht und Schneidklemme entsteht und ein Eindringen von Feuchtigkeit und anderen Kontaminationen verhindert wird.

In elektrischen Verbindern findet die Datenübertragung vorzugsweise auf differentiellen Leitungen statt. Eine differentielle Leitung weist eine erste Leiterbahn und eine zweite Leiterbahn auf. Die häufig als Plus-Leiterbahn oder Tip-Leiterbahn benannte Leiterbahn ist hier und im Folgenden die erste Leiterbahn, wohingegen die Minus-Leiterbahn oder auch Ring-Leiterbahn hier und im Folgenden als zweite Leiterbahn definiert ist. Auf der ersten Leiterbahn wird ein Signal übertragen, während die zweite Leiterbahn das invertierte Signal transmittiert. Der Empfänger bildet die Differenz zwischen den beiden Signalen, wobei die Differenz dem ursprünglichen zu übertragenden Signal entspricht.

Auf der Leiterplatte sind vier differentielle Leitungen ausgebildet, es können allerdings auch mehr oder weniger differentielle Leitungen ausgebildet sein. Jeweils eine erste und eine zweite Leiterbahn bilden dabei eine differentielle Leitung aus. Die Leiterbahnen sind von eins bis acht definiert, wobei die Leiterbahnen eins und zwei, die Leiterbahnen drei und sechs, die Leiterbahnen vier und fünf und die Leiterbahnen sieben und acht jeweils eine differentielle Leitung ausbilden. Auf der Leiterplatte sind zudem Kompensationseinheiten in Form von Plattenkondensatoren angeordnet, wobei die Plattenkondensatoren auch als Interdigitalkondensatoren ausgestaltet sein können. Die Kapazität eines Plattenkondensators ist in einem vereinfachten Modell direkt proportional zur relativen Permittivität des Dielektrikums und zur kleinsten Plattenfläche. Zudem ist die Kapazität reziprok zum Abstand der Platten zueinander.

Gemäß einer vorteilhaften Ausgestaltung der Erfindung sind auf einer inneren Leiterplattenlage mehr oder gleich viele Leitflächen ausgebildet als auf der anderen inneren Leiterplattenlage. Es kann auch auf einer inneren Leiterplattenlage keine Leitfläche ausgebildet sein. Weist die Leiterplatte mehr als 2 innere Leiterplattenlagen auf, kann auch auf mehr als einer Leiterplattenlage keine Leitfläche ausgebildet sein.

Gemäß einer besonders bevorzugten Ausgestaltung der Erfindung macht die Fläche der Leitfläche maximal annähernd zwischen 0,5 % bis 100 % der Fläche der Leiterplattenlage aus. Vorzugsweise beträgt die Fläche der Leitfläche maximal annähernd 100 %, bevorzugt 75 %, besonders bevorzugt 35 %, im Besonderen bevorzugt 15 %, ganz besonders bevorzugt 5 %, im äußersten bevorzugt 2 %, im aller äußersten bevorzugt 1 %, am bevorzugtesten 0,5 % der Fläche der Leiterplattenlage.

Vorteilhafterweise macht die Gesamtfläche aller Leitflächen mindestens annähernd zwischen 2 % bis 125 % der Fläche der Leiterplattenlage aus. Vorzugsweise beträgt die Gesamtfläche aller Leitflächen mindestens annähernd 2 %, besonders bevorzugt 5 %, im Besonderen bevorzugt 15 %, ganz besonders bevorzugt 30 %, im äußersten bevorzugt 75 %, im aller äußersten bevorzugt 125 % der Fläche der Leiterplattenlage.

In einer vorteilhaften Weiterbildung der Erfindung macht die Gesamtfläche aller Leitflächen auf einer Leiterplattenlage mindestens annähernd zwischen 2 % bis 100 % der Fläche der Leiterplattenlage aus. Vorzugsweise beträgt die Gesamtfläche aller Leitflächen auf einer Leiterplattenlage mindestens annähernd 2 %, besonders bevorzugt 5 %, im Besonderen bevorzugt 10 %, ganz besonders bevorzugt 20 %, im äußersten bevorzugt 50 %, im aller äußersten bevorzugt 100 %, der Fläche der Leiterplattenlage. Ziel ist es, so viele Leitflächen mit einer möglichst großen Fläche auf einer oder mehrerer Leiterplattenlagen auszubilden, um dadurch eine möglichst große Stabilität des Leiterplattenaufbaus zu erzielen.

Gemäß einer bevorzugten Ausgestaltung der Erfindung weist die Leitfläche die Form eines Ovals oder eines Kreises oder eines Vielecks, vorzugsweise eines Vierecks oder Dreiecks oder eines Trapezes oder eines Kreises oder eines Parallelogramms, auf. Innerhalb der Leitflächen können Freiflächen ausgebildet sein, insbesondere dann, wenn überlappend zu den Freiflächen eine Leiterbahn ausgebildet ist. Die Freiflächen können jegliche Form und Größe annehmen. Auch kann eine solche Freifläche am Rand angeordnet sein, sodass innerhalb der Leitfläche eine Auskerbung ausgebildet ist. Die Auskerbung kann rund, eckig oder ähnliches sein. Die Leitfläche ist stets so ausgebildet, dass diese sich an die Umgebung auf der Leiterplatte anpasst und möglichst zu keinem signalführenden Bereich überlappend angeordnet ist. Zudem kann innerhalb der Freifläche der Leitfläche ein Via durchgeführt werden. Dazu darf das leitende Material des Vias einen normativ festgelegten Mindestabstand zu der Leitfläche nicht unterschreiten. Es können zwei oder mehr Vias in einer oder mehrerer Freiflächen einer Leitfläche angeordnet werden.

In einer besonders günstigen Ausgestaltung der Erfindung sind vorzugsweise mehr als fünf, besonders bevorzugt mehr als zehn, ganz besonders bevorzugt mehr als zwanzig, im äußersten bevorzugt mehr als fünfzig, im aller äußersten bevorzugt mehr als einhundert Leitflächen auf der Leiterplatte angeordnet.

In einer vorteilhaften Weiterbildung der Erfindung sind zumindest zwei Leitflächen auf unterschiedlichen Leiterplattenlagen vollständig überlappend zueinander angeordnet. Es können allerdings auch mehr als zwei Leitflächen vollständig überlappend zueinander angeordnet sein. Vorzugsweise sind alle Leitflächen überlappend zueinander angeordnet. Wird eine Leiterplatte verwendet, welche mehr als zwei innere Leiterplattenlagen aufweist, so können auch drei oder mehr Leitflächen, welche auf drei oder mehr Leiterplattenlagen angeordnet sind, überlappend beziehungsweise vollständig überlappend zueinander angeordnet sein.

Gemäß einer besonders bevorzugten Ausgestaltung der Erfindung ist keine Leitfläche zu einem Leitungspfad überlappend angeordnet. Vorzugsweise ist keine Leitfläche zu einem signalführenden Bauteil, insbesondere dem Leitungspfad und den Kontaktpads, überlappend angeordnet. Vorzugsweise ist auch keine Leitfläche zu einer Stichleitung oder Kompensationseinheit überlappend angeordnet. Eine Überlappung der Leitfläche, insbesondere mit signalführenden Pfaden, würde die Schaltungseigenschaften beeinflussen, was sich negativ auf die Übertragungsleistung auswirken könnte und eine Abänderung des Schaltungsdesigns eventuell nach sich ziehen müsste.

In einer besonders bevorzugten Ausgestaltung der Erfindung sind die Leitflächen in mindestens einer Reihe ausgebildet, wobei eine Reihe zwei Leitflächen aufweist, wobei die Leitflächenmittelpunkte der Leitflächen einer Reihe auf einer gedachten Linie liegen, wobei die Linie parallel zu der Längsachse oder zu der Breitachse angeordnet ist.

Gemäß einer günstigen Weiterbildung der Erfindung sind die Leitflächen in mindestens einer Gruppe angeordnet, wobei sich eine Gruppe aus zwei zueinander überlappenden Reihen, vorzugsweise vollständig überlappenden Reihen, zusammensetzt. Um eine Gruppe auszubilden, muss dabei nicht die vollständige Reihe herangezogen werden. Es ist ausreichend, wenn zumindest zwei Mitglieder einer Reihe bei der Ausbildung einer Gruppe mit involviert sind.

Vorteilhafterweise ist die Leitfläche aus einem elektrisch leitenden Material, vorzugsweise aus Kupfer oder Aluminium, ausgebildet. Die Leitflächen können allerdings auch aus jedem anderen Material ausgebildet sein, welches den Leiterplattenlagenaufbau stabilisiert.

Gemäß einer besonders bevorzugten Ausgestaltung der Erfindung ist der elektrische Verbinder als Steckbuchse ausgebildet. Der elektrische Verbinder kann auch als Steckverbinder oder als Anschlussdose ausgebildet sein. Zudem kann die Erfindung auch in Anwendungen eingesetzt werden, welche mehrere Steckbuchsen oder Steckverbinder parallel oder übereinander angeordnet haben.

Überlappung ist im Vorherigen, hier und im Folgenden so definiert, dass mindestens ein Vektor existiert, der zwei im Raum angeordnete Flächen schneidet, wobei der Vektor eine der Flächen orthogonal schneidet. Eine vollständige Überlappung ist gegeben, wenn es keinen Vektor gibt, der, wenn er eine der beiden Flächen orthogonal schneidet, nicht auch die andere Fläche schneidet.

Die Vorderseite (Vorne) ist die Seite, die in einen anderen elektrischen Verbinder einführbar ist oder die Seite, in die ein anderer elektrischer Verbinder eingeführt wird. Die Hinterseite (Hinten) ist die Seite, in die ein Anschlusskabel in den elektrischen Verbinder einführbar ist.

Die Längsachse ist diejenige Achse, die die Vorderseite und die Hinterseite orthogonal schneidet. Die Querachse ist diejenige Achse, die die Oberseite und Unterseite orthogonal schneidet. Die Breitachse ist diejenige Achse, die die Flächen in denen die beiden Seitenflächen des Gehäuseunterteils angeordnet sind orthogonal schneidet. Die Breitachse steht orthogonal auf der Längsachse und orthogonal auf der Querachse.

Eine Ebene ist eine unendlich ausgedehnte Fläche im dreidimensionalen Raum in zwei Raumrichtungen, wobei die Raumrichtung, die nicht diese Fläche aufspannt, die Querachse ist. Die Ebene im Raum, in der das Dach des Gehäuseoberteils angeordnet ist, ist als Oberseite der Steckbuchse definiert. Die Ebene im Raum, in der der Boden des Gehäuseunterteils angeordnet ist, ist als Unterseite der Steckbuchse definiert.

Eine Stichleitung ist eine Leitung, die nicht im Signalpfad angeordnet ist. Der Signalpfad ist der Pfad, über den ein über den elektrischen Verbinder übertragenes Signal auf direktem Weg transmittiert wird.

Im Folgenden wird ein Ausführungsbeispiel der Erfindung anhand von Figuren erläutert. Es zeigen:
- Fig. 1: eine perspektivische Ansicht des elektrischen Verbinders in Explosionsdarstellung, aufweisend ein Gehäuse, ein Ladestück, ein Trägerelement, eine Leiterplatte mit Kontaktelementen, einer Abdeckung und ein Schirmteil,
- Fig. 2: eine perspektivische Ansicht einer Leiterplatte, auf welcher Kontaktelemente angeordnet sind,
- Fig. 3: eine perspektivische Ansicht aller leitender Flächen der Leiterplatte aus Fig. 2,
- Fig. 4: eine Draufsicht auf die Leiterplatte aus Fig. 2,
- Fig. 5: eine Draufsicht auf die leitenden Flächen der inneren Leiterplattenlage eins,
- Fig. 6: eine Draufsicht auf die leitenden Flächen der inneren Leiterplattenlage zwei,

In den nachfolgenden Figuren bezeichnen gleiche Bezugszeichen gleiche Teile mit gleicher Bedeutung.

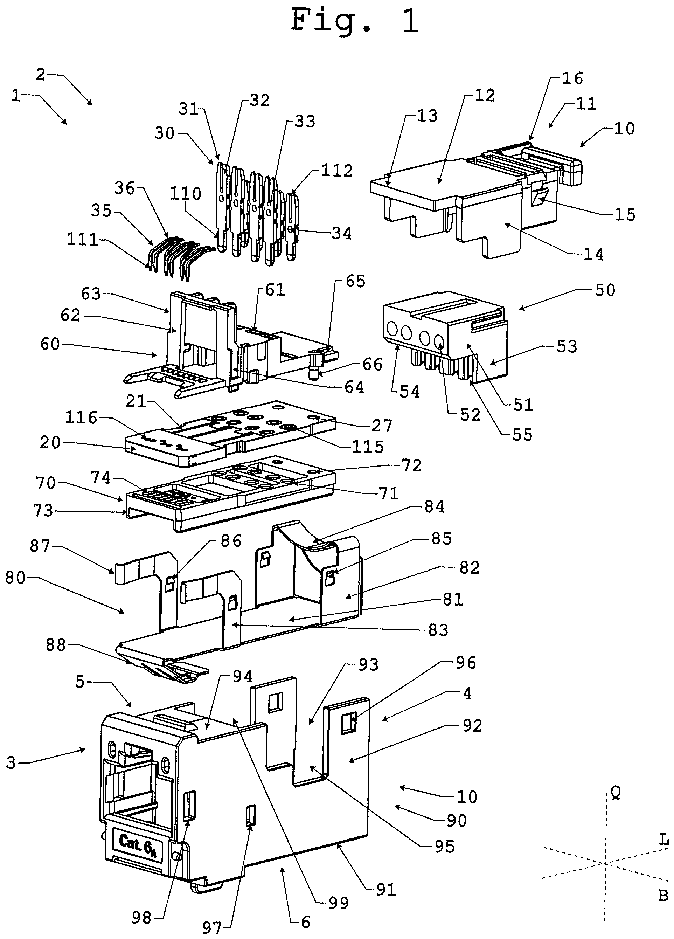

In Fig. 1 ist ein elektrischer Verbinder 1 aufgezeigt, welcher als Steckbuchse 2 ausgebildet ist. Die Steckbuchse 2 weist ein Gehäuse 10 auf, wobei das Gehäuse 10 in ein Gehäuseoberteil 90 und ein Gehäuseunterteil 12 gliederbar ist. Sowohl Gehäuseunterteil 12 als auch Gehäuseoberteil 90 sind aus einem leitenden Material, insbesondere aus einem metallenen Gehäuse 10 ausgebildet. Dadurch werden die elektromagnetische Verträglichkeit sowie die elektromagnetische Störaussendung reduziert. Das metallene Gehäuse 10 kann beispielsweise aus Blech oder einem Metalldruckgussteil, insbesondere einem Zinkdruckgussteil ausgebildet sein.

Das Gehäuseunterteil 12 weist eine Vorderseite 3 und eine Hinterseite 4 auf, wobei die Vorderseite 3 diejenige Seite ist, in welche ein komplementärer Stecker eingeführt wird und die Hinterseite 4 diejenige Seite ist, in welche ein Kabel (nicht gezeigt) in die Steckbuchse 2 eingeführt wird. Die Vorderseite 3 weist hierfür ein Fenster auf, welches die typische Form eines RJ45-Steckers innehat. Das Gehäuseunterteil 90 weist einen Boden 91 und ausgehend vom Boden 91 zwei in Richtung Gehäuseoberteil 11 zeigende Seitenflächen 92 auf. Der Boden 91 und die beiden Seitenflächen 92 verbinden Vorderseite 3 und Hinterseite 4 miteinander. Die Hinterseite 4 weist eine Freifläche 93 auf.

Im Bereich der Vorderseite 3 weist das Gehäuseunterteil 90 ein Dach 94 auf. Das Dach 94 verläuft parallel zum Boden 91. Die Ebene im Raum, in der der Boden 91 des Gehäuseunterteils 90 angeordnet ist, ist als Unterseite 6 der Steckbuchse 2 definiert. Die Ebene im Raum, in der das Dach 94 angeordnet ist, ist als Oberseite 5 der Steckbuchse 2 definiert. Jede Seitenfläche 92 weist eine L-förmige Ausbuchtung 95 auf. Zusätzlich weist die Seitenfläche 92 Haltemittel, welche vorzugsweise als Ausbuchten 96-98 ausgebildet sind, auf. Insgesamt sind jeweils drei Ausbuchtungen 96-98 an einer Seitenfläche 92 ausgebildet. Die erste Ausbuchtung 96 ist im Bereich der Hinterseite 4 und Oberseite 5 angeordnet. Die zweite Ausbuchtung 97 ist in der Mitte der Seitenfläche 92 angeordnet und die dritte Ausbuchtung 98 ist im mittleren Bereich nahe der Vorderseite 3 angeordnet.

Innerhalb des Gehäuseunterteils 90 ist im zusammengesetzten Zustand ein Schirmteil 80 angeordnet. Das Schirmteil 80 weist eine Grundplatte 81 auf, wobei die Grundplatte 81 an dem Boden 91 des Gehäuseunterteils 90 aufliegt. Die Grundplatte 81 bildet an der Vorderkante ein Befestigungselement 88 aus, welches in Richtung der Unterseite 6 der Steckbuchse 2 zeigt. Das Schirmteil 80 wird durch das Befestigungselement 88 und durch ein komplementäres Haltemittel (nicht gezeigt) des Gehäuseunterteils 90 an dem Gehäuseunterteil 90 fixiert. In der Nähe der Hinterseite 4 weist das Schirmteil 80 zwei erste Außenflächen 82 auf, wobei die ersten Außenflächen 82 parallel zu den Seitenflächen 92 des Gehäuseunterteils 90 verlaufen. Die beiden ersten Außenflächen 82 sind im Bereich der Oberseite 5 über einen Überhang 84 miteinander verbunden. Der Überhang 84 weist einen bogenförmigen Verlauf auf, wobei der bogenförmige Verlauf des Überhangs 84 in Richtung des Innenraums der Steckbuchse 2 abnehmend ist. Der Überhang 84 ist der Hinterseite 4 näher angeordnet als das Ladestück 50. Im zusammengesetzten Zustand der Steckbuchse 2 verlaufen die in der Hinterseite 4 eingeführten Einzeladern eines Kabels über den bogenförmigen Verlauf des Überhangs 84 in das Ladestück 50. Das Dach weist zudem ein Fixierelement 16 auf, welches über die Hinterseite 4 der Steckbuchse 2 hinausragt. Mithilfe eines Kabelbinders (nicht gezeigt) und dem Fixierelement 16 kann das einzuführende Kabel an der Steckbuchse 2 mechanisch zusätzlich fixiert werden.

Zudem weisen die ersten Außenflächen 82 Haltemittel, in Form von ersten Rastnasen 85 auf. Die ersten Rastnasen 85 zeigen in Richtung des Innenraums der Steckbuchse 2. In der Mitte des Schirmteils 80 sind zwei L-förmige zweite Außenflächen 83 angeordnet. Die zweiten Außenflächen 83 verlaufen parallel zu den Seitenflächen 92 des Gehäuseunterteils 90. Am freien Ende der L-förmig ausgestalteten zweiten Außenfläche 83 ist eine Haltenase 87 angeordnet, welche in Richtung der Seitenflächen 92 des Gehäuseunterteils 90 zeigen. Im zusammengesetzten Zustand greift die Haltenase 87 in die dritte Ausbuchtung 98 des Gehäuseunterteils 90 ein. Beim Einführen eines komplementären Steckverbinders in die Steckbuchse 2 werden die L-förmigen zweiten Außenflächen 83 in Richtung der Seitenflächen 92 des Gehäuseunterteils 90 gedrückt, wobei die Haltenasen 87 verstärkt in die dritte Ausbuchtung 98 des Gehäuseunterteils 90 eingepresst werden. Das Schirmteil 80 und die Schirmung des Steckverbinders kontaktieren dabei unter anderem über die L-förmigen zweiten Außenflächen 83. Die Schirmübergabe von der Steckbuchse 2 zum Steckverbinder findet in diesem Bereich statt. Die zweiten Außenflächen 83 weisen Haltemittel, in Form von zweiten Rastnasen 86 auf. Die zweiten Rastnasen 86 zeigen in Richtung des Innenraums der Steckbuchse 2.

Das Gehäuseoberteil 11 ist U-förmig ausgebildet. Es weist ein Dach 12 auf, welches im Raum in der Oberseite 5 der Steckbuchse 2 angeordnet ist. Das Dach 12 weist ein Vordach 13 auf, welches sich im zusammengesetzten Zustand in eine Ausstülpung 99 des Dachs 94 des Gehäuseunterteils 90 einschmiegt. Zudem weist das Gehäuseoberteil 11 eine Seitenwand 14 auf, wobei ein Teil der Seitenwand 14 L-förmig ausgebildet ist und sich in die L-förmige Ausbuchtung 95 der Seitenfläche 92 des Gehäuseunterteils 90 im zusammengesetzten Zustand einschmiegt. Der Bereich der Seitenwand 14, der der Hinterseite 4 näher angeordnet ist, ist in Richtung Steckbuchsen 2 Mitte eingerückt und weist ein Haltemittel, welches vorzugsweise als Nase 15 ausgebildet ist, auf. Das Gehäuseoberteil 11 ist mittels einer Schnapp-Füge-Verbindung mit dem Gehäuseunterteil 90 verbindbar. Dabei greift die Nase 15 des Gehäuseoberteils 11 in die erste Ausbuchtung 96 des Gehäuseunterteils 90.

In dem Gehäuseoberteil 11 ist ein Ladestück 50 angeordnet, wobei das Ladestück 50 aus einem nicht elektrisch leitenden Material, insbesondere aus Kunststoff, ausgebildet ist. Der Körper des Ladestücks 50 ist L-förmig ausgebildet. Der erste Schenkel 51 des L-förmigen Körpers, welcher parallel zur Oberseite 5 der Steckbuchse 2 verläuft, weist vorzugsweise vier Durchgangslöcher 52 auf, durch welche die Einzeladern des einzuführenden Kabels durchgeführt werden. Zudem sind an der der Oberseite 5 abgewandten Seite Führungen 54 im ersten Schenkel 51 angeordnet, durch welche eine Reihe von Schneidklemmen 31 durchführbar ist. Der zweite Schenkel 53 des L-förmigen Körpers steht senkrecht auf der Oberseite 5 der Steckbuchse 2 und weist Aushöhlungen 55 auf. Durch die Führungen 54 des ersten Schenkels 51 und den Aushöhlungen 55 des zweiten Schenkels 52 sind erste Kontaktelemente 30, welche vorzugsweise als Schneidklemmen 31 ausgebildet sind, einführbar. Beim Zusammensetzten der Steckbuchse 2 dringen die Schneidklemmen 31 in die Führungen 54 bzw. Aushöhlungen 55 ein, wodurch die Einzeladern des eingeführten Kabels abisoliert werden und sich eine elektrische Verbindung einstellt.

Die Schneidklemmen 31 sind in Nähe der Hinterseite 4 angeordnet. Die Schneidklemmen 31 zeigen in Richtung Gehäuseoberteil 11. Die Schneidklemme 31 weist einen Fuß 110 auf, der durch eine erste Durchgangsöffnung 115 durchführbar ist. Der Fuß 110 der Schneidklemme 31 wird mittels einer Lötung oder einer Pressung mit dem ersten Kontaktpad 117 elektrisch und mechanisch kontaktiert. Die Schneidklemme 31 weist in dessen Mitte ein Loch 34 auf. Beim Zusammensetzen der Steckbuchse 2 sind die Einzeladern im Ladestück 50 angeordnet. Die Isolierung der Einzeladern wird von den Klemmelementen der Schneidklemme 31 abisoliert und es entsteht eine elektrische Verbindung zwischen Schneidklemme 31 und Einzelader. Im zusammengesetzten Zustand sind die abisolierten Einzeladern oberhalb des Lochs 34 angeordnet. Der Fuß 110 der Schneidklemme 31 ragt auf der dem Gehäuseunterteil 90 zugewandten Seite der Leiterplatte heraus und schmiegt sich in eine Aushöhlung 71 der Abdeckung 70 ein.

Die Schneidklemmen 31 sind in zwei Reihen angeordnet, wobei eine Reihe dadurch charakterisiert ist, dass die Füße 110 der Schneidklemmen 31 einer Reihe von der Hinterseite 4 des Steckverbinders gleich weit weg angeordnet sind. Die Schneidklemmen 31 können in einer Reihe oder in mehr als einer Reihe angeordnet sein, beispielsweise in zwei drei, vier oder fünf Reihen. Die Schneidklemmenflächen 32 sind vorliegend parallel zueinander ausgerichtet. Die Schneidklemmenflächen 32 unterschiedlicher Reihen können einen Winkel zueinander aufweisen. Die Schneidklemmenflächen 32 von Schneidklemmen 31 einer Reihe können unterschiedliche Winkel zueinander aufweisen. Die Schneidklemmenflächen 32 können senkrecht aufeinander stehen.

Die Schneidklemmen 31 einer Reihe können eine andere Höhe wie die Schneidklemmen 31 einer anderen Reihe aufweisen, wobei die Höhe einer Schneidklemme 31, der Abstand zwischen dem Punkt der Schneidklemme 31, in den ein Kabel eingeführt werden kann und der Leiterplattenoberseite ist. Die Schneidklemmen 31 innerhalb einer Reihe können unterschiedliche Höhen zueinander aufweisen. Dadurch ist es möglich, die Steckbuchse 2 kompakter auszugestalten, da der Bauraum optimiert genutzt wird, indem die Einzeladern übereinander in dem Ladestück 50 angeordnet werden können. Über eine Leiterbahn 21 ist jeweils eine Schneidklemme 31 mit einem zweiten Kontaktelement 35, welches vorzugsweise als Steckkontakt 36 ausgebildet ist, elektrisch verbunden.

Die Steckkontakte 36 sind in der Nähe der Vorderseite 3 der Steckbuchse 2 angeordnet. Die Steckkontakte 36 weisen einen Fuß 111 auf, welcher in eine zweite Durchgangsöffnung 116 auf der Leiterplatte 20 geführt wird und mittels einer Pressung und/oder Lötung mechanisch fixiert und elektrisch kontaktiert wird. Die Steckkontakte 36 sind stiftartig ausgebildet, wobei die Stecckontakte 36 aufsteigend in Richtung Hinterseite 4 der Steckbuchse 2 ragen. Die Steckkontakte 36, welche mit den Leiterbahnen drei 103 und sechs 106 verbunden sind, sind kürzer als die anderen Steckkontakte 36 ausgebildet. Zudem sind die Steckkontakte 36 federnd ausgebildet.

Oberhalb der Leiterplatte 20 ist ein Trägerelement 60 angeordnet, das Aussparungen 61 aufweist, durch welche die Schneidklemmen 31 geführt werden. Im mittleren Bereich des Trägerelements 60 ist eine Erhöhung 62 ausgebildet, welche im zusammengesetzten Zustand das Dach 12 des Gehäuseoberteils 11 berührt. An der Außenfläche 63 der Erhöhung 62 ist eine erste Einkerbung 64 angeordnet, in welche die zweite Rastnase 86 des Schirmteils 80 eingreift. Zudem ist im Bereich der Hinterseite 4 eine weitere zweite Einkerbung 65 ausgebildet, in welche die erste Rastnase 85 des Schirmteil 80 eingreift. Durch das Eingreifen der beiden Rastnasen 85, 86 wird das Trägerelement 60 an dem Schirmteil 80 mechanisch fixiert. Das Trägerelement 60 weist im Bereich der Hinterseite 4 an dessen unterer Seite zwei Stifte 66 auf, die in zwei komplementäre Löcher 27 auf der Leiterplatte 20 und zwei Einbuchtungen 72 in der Abdeckung 70 einführbar sind und eine Verschiebung entlang einer Ebene verhindern.

Unterhalb der Leiterplatte 20 ist die Abdeckung 70 angeordnet. Die Abdeckung 70 weist Schienen 73 auf, welche an der Grundplatte 81 des Schirmteils 80 aufliegen. Zudem weist die Abdeckung 70 Aushöhlungen 71, 74 auf, in welche die durch die Leiterplatte 20 geführten Füße 110, 111 der Steckkontakte 36 und der Schneidklemmen 31 eindringen können.

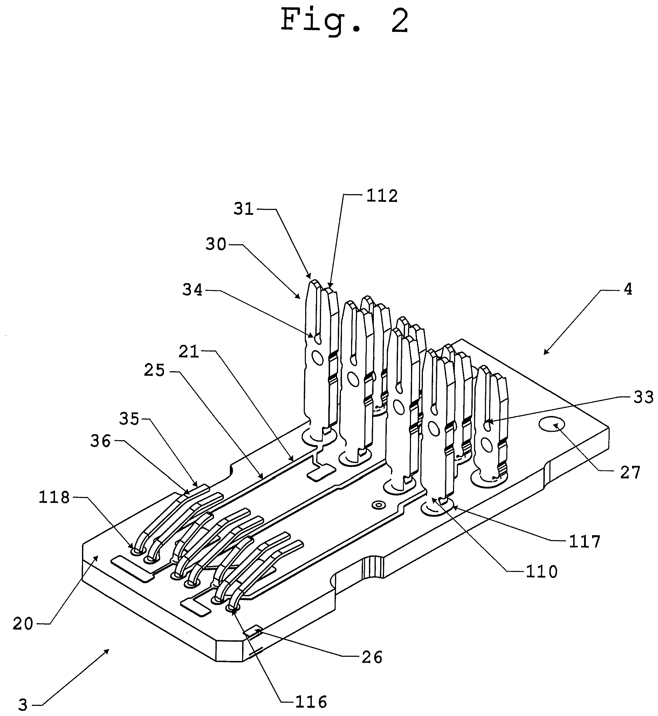

In Fig. 2 ist die Leiterplatte 20 mit auf ihnen angeordneten Steckkontakten 36 und Schneidklemmen 31 abgebildet. Die Stecckontakte 36 sind in zwei Reihen angeordnet, wobei die Anzahl der Steckkontakte 36 innerhalb einer Reihe variiert. Die Reihe, die näher an der Vorderseite 3 der Steckbuchse 2 angeordnet ist, weist sechs Steckkontakte 36 auf, wohingegen die Reihe, die weiter von der Vorderseite 3 der Steckbuchse 2 angeordnet ist, zwei Steckkontakte 36 aufweist. Die Reihenanzahl sowie die Anzahl der Steckkontakte 36 innerhalb einer Reihe sind veränderbar. Die Steckkontakte 36 der zweiten Reihe sind kürzer ausgebildet als die anderen Steckkontakte 36. Die Steckkontakte 36 können in Bezug auf die Leiterplatte 20 unterschiedliche Höhen erreichen und unterschiedlich weit in Richtung Leiterplattenmitte hineinragen.

Zudem ist in Fig. 2 deutlich zu erkennen, dass die Schneidklemmen 31 der unterschiedlichen Reihen in Bezug auf die Leiterplatte 20 unterschiedliche Höhen aufweisen und die Schneidklemmenflächen 32 parallel zueinander verlaufen. Jeweils eine Leiterbahn 21 verbindet eine Schneidklemme 31 mit einem Steckkontakt 36. Eine Leiterbahn 21 weist dabei ein erstes Kontaktpad 117 und ein zweites Kontaktpad 118, welche um eine erste Durchgangsöffnung 115 und eine zweite Durchgangsöffnung 116 angeordnet sind und über einen Leitungspfad 25 elektrisch verbunden werden, auf. Der Leitungspfad 25 kann dabei über verschiedene Leiterplattenlagen 26 verlaufen und unterschiedliche Leiterbahnbreiten aufweisen. Es hat sich als vorteilhaft erwiesen, dass ausgehend von der Schneidklemme 31 die Breite der Leiterbahn 21 immer kleiner wird und der Abstand der Leiterbahnen 21 beispielsweise einer differentiellen Leitung 22 sich vergrößert. Das ist vorteilhaft, da die Impedanz der Schneidklemme 31 deutlich größer ist als die Impedanz des Steckkontakts 36 und mit einer stufenweisen Anpassung der Impedanz des Leitungspfades 25 sich die Einfügedämpfung und Rückflussdämpfung deutlich verbessert.

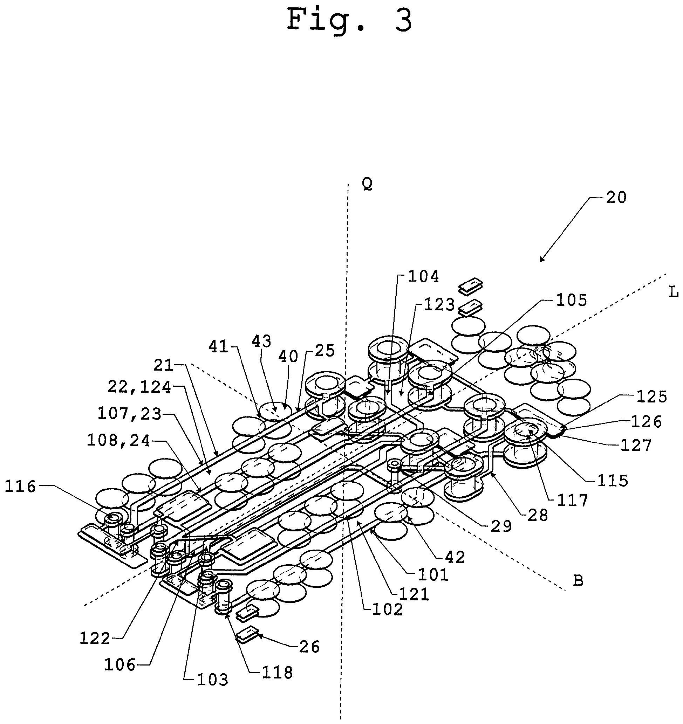

In Fig. 3 sind alle leitenden Flächen, welche auf der Leiterplatte 20 angeordnet sind, gezeigt. Diejenigen leitenden Flächen, die aufgrund der Perspektive hinter anderen leitenden Flächen angeordnet sind, sind gestrichelt abgebildet.

Insgesamt weist die Leiterplatte 20 acht Leiterbahnen 21 auf. Jeweils zwei Leiterbahnen 21 bilden eine differentielle Leitung 22 aus, wobei bei den beiden Leiterbahnen 21 einer differentiellen Leitung 22 zwischen erster Leiterbahn 23 und zweiter Leiterbahn 24 unterschieden wird. Damit sind auf der Leiterplatte 20 vier erste Leiterbahnen 23 und vier zweite Leiterbahnen 24 angeordnet. Die vier ersten Leiterbahnen 23 sind als die Leiterbahn eins 101, Leiterbahn drei 103, Leiterbahn fünf 105 und Leiterbahn sieben 107 definiert, wohingegen die zweiten Leiterbahnen 24 als die Leiterbahn zwei 102, Leiterbahn vier 104, Leiterbahn sechs 106 und Leiterbahn acht 108 definiert sind. Die Leiterbahn eins 101 und die Leiterbahn zwei 102 bilden eine erste differentielle Leitung 121 aus. Die Leiterbahn drei 103 und die Leiterbahn sechs 106 bilden eine zweite differentielle Leitung 122 aus. Die Leiterbahn vier 104 und die Leiterbahn fünf 105 bilden eine dritte differentielle Leitung 123 aus und die Leiterbahn sieben 107 und die Leiterbahn acht 108 bilden eine vierte differentielle Leitung 124 aus. Die Leiterbahnen 21 einer differentiellen Leitung 22 können auf unterschiedlichen Leiterplattenlagen 26 verlaufen, wobei die Einzelabschnitte der Leiterbahnen auf den unterschiedlichen Leiterplattenlagen 26 zumeist mittels Vias 29 verbunden sind.

Die Leiterplatte 20 weist insgesamt neun Kompensationseinheiten 125 auf, wobei die Kompensationseinheiten 125 als Plattenkondensatoren 126 ausgestaltet sind. Ein Plattenkondensator 126 weist zwei zueinander parallel verlaufende, leitende Platten 127 auf. Zwischen den Platten 127 ist ein Dielektrikum angeordnet. Durch die Wahl, auf welchen Leiterplattenlagen 26 die Platten 127 des Plattenkondensators 126 angeordnet werden, ist die Kapazität des Plattenkondensators 126 veränderbar. Auch über die Größe der Flächen der Platten 127 des Plattenkondensators 126 ist die Kapazität veränderbar. Die Platten 127 der Plattenkondensatoren 126 sind vorzugsweise viereckig und nahezu vollständig überlappend zueinander angeordnet. Die Platten 127 können allerdings auch vieleckig, rund oder oval ausgebildet sein. Die Platten 127 der Plattenkondensatoren 126 sind zum Beispiel über Stichleitungen 28 mit einer Leiterbahn 21 verbunden. Dabei kann die Stichleitung 28 mit einem Kontaktpad 117, 118 oder dem Leitungspfad 25 verbunden sein.

Zwei der neun Plattenkondensatoren 126 sind zwischen der Leiterbahn eins 101 und Leiterbahn drei 103 geschaltet, wobei ein Plattenkondensator 126 nahe der Schneidklemmen 31 und der andere Plattenkondensator 126 nahe den Steckkontakten 36 angeordnet ist. Ein anderer Plattenkondensator 126 ist zwischen die Leiterbahn sechs 106 und die Leiterbahn acht 108 geschaltet. Ein anderer Plattenkondensator 126 ist zwischen die Leiterbahn vier 104 und die Leiterbahn sechs 106 geschaltet. Ein anderer Plattenkondensator 126 ist zwischen die Leiterbahn drei 103 und die Leiterbahn fünf 105 geschaltet. Ein anderer Plattenkondensator 126 ist zwischen die Leiterbahn fünf 105 und die Leiterbahn sechs 106 geschaltet. Ein anderer Plattenkondensator 126 ist zwischen die Leiterbahn zwei 102 und die Leiterbahn vier 104 geschaltet. Ein anderer Plattenkondensator 126 ist zwischen die Leiterbahn vier 104 und die Leiterbahn acht 108 geschaltet. Ein anderer Plattenkondensator 126 ist zwischen die Leiterbahn drei 103 und die Leiterbahn sieben 107 geschaltet. Die Plattenkondensatoren 126 können ebenfalls als Interdigitalkondensatoren ausgebildet sein.

Die Leitflächen 40 sind in den inneren Leiterplattenlagen 26 ausgebildet. Es können allerdings auch Leitflächen 40 in der obersten Leiterplattenlage 26 und in der untersten Leiterplattenlage 26 angeordnet sein. Insgesamt sind sechsundvierzig Leitflächen 40 auf der Leiterplatte 20 angeordnet. Es können allerdings auch mehr oder weniger Leitflächen 40 auf der Leiterplatte 20 angeordnet sein. Zudem können unterschiedlich viele Leitflächen 40 auf den einzelnen Leiterplattenlagen 26, insbesondere auf den inneren Leiterplattenlagen 26 angeordnet sein. Die Anzahl der Leitflächen 40 ist derart ausgewählt, dass die Leitflächen 40 vorzugsweise nicht überlappend zu einer leitenden Fläche der Schaltung, insbesondere der Signalpfade, angeordnet sind. Als Signalpfad ist derjenige Pfad definiert, welcher ein Signal durch die Steckbuchse 2 auf direktem Pfad transmittiert. Die Leitfläche 40 kann überlappend zu einer Leiterbahn 21 insbesondere einem Signalpfad angeordnet sein. Die Leitfläche 40 sollte jedoch nicht zu mehr als einem Signalpfad überlappend angeordnet sein, da der Einfluss auf die Impedanz und damit auf die Einfügedämpfung und Rückflussdämpfung aber auch auf die Kompensationsschaltung zu groß und eine Änderung des Schaltungsdesigns vonnöten werden würde, um die gleiche Übertragungsleistung zu gewährleisten und die normativen Anforderungen einzuhalten. Es können mehrere Leitflächen 40 einen Leitungspfad 25 oder ein Kontaktpad 117, 118 überlappen. Bevorzugt überlappt eine Leitfläche 40 keine zwei Leitungspfade 25 oder zwei Kontaktpads 117, 118 oder ein Leitungspfad 25 und ein Kontaktpad 117, 118. Bestenfalls weisen die Leitflächen 40 überhaupt keinen Einfluss oder keinen messbaren Einfluss auf die leitenden Flächen auf der Leiterplatte 20 auf, dies wird insbesondere dadurch bewerkstelligt, dass keine Leitfläche 40 unterhalb oder oberhalb eines Leitungspfades 25 oder Kontaktpads 117, 118 angeordnet ist.

Die Leitflächen 40 können überlappend zu den Kompensationseinheiten 125, welche vorzugsweise als Plattenkondensatoren 126 ausgebildet sind, angeordnet sein. Der Einfluss der Leitflächen 40 auf die Kapazitäten der Plattenkondensatoren 126 ist zumeist vernachlässigbar. Ebenfalls kann eine Leitfläche 40 oder können mehrere Leitflächen 40 überlappend zu einer Stichleitung 28 angeordnet sein. Dabei ist es unerheblich, ob die Stichleitung 28 mit einem Kontaktpad 117, 118 oder mit einem Leitungspfad 25 verbunden ist.

Die Ausbildung der Leitflächen 40 wird derart ausgestaltet, dass die Leitflächen 40 klein genug sind, um eine oder keine Leiterbahn 21 zu überlappen, jedoch groß genug, um dem Lagenaufbau Stabilität zu verleihen. Zudem soll so viel Fläche einer Leiterplattenlage 26 mit Leitflächen 40 bedeckt sein wie möglich. Zum Rand der Leiterplattenlage 26 wird vorzugsweise ein Mindestabstand eingehalten. Die Leitflächen 40 können allerdings auch direkt am Rand einer Leiterplattenlage 26 angeordnet sein.

Die Leitflächen 40 sind vorzugsweise in Reihen 41 auf der Leiterplatte 20 angeordnet, können allerdings auch einzeln auf der Leiterplatte 20 angeordnet sein. Eine Reihe 41 weist mindestens zwei Leitflächen 40 auf, wobei der Leitflächenmittelpunkte 43 der Leitflächen 40 einer Reihe 41 auf einer gedachten Linie liegen, wobei die Linie parallel zu der Längsachse L oder zu der Breitachse B angeordnet ist. Die Längsachse L steht dabei orthogonal auf der Breitachse B und Querachse Q. Dabei kann eine Leitfläche 40 Teil von zwei oder mehr Reihen 41 sein. Die Leiterplatte 20 weist in der derartigen Anordnung zweiunddreißig Reihen 41 auf, wobei jede Leiterplattenlage 26 sechszehn Reihen 41 ausbildet. Auf jeder Leiterplattenlage 26 sind vier Reihen 41 mit drei Leitflächen 40, elf Reihen 41 mit zwei Leitflächen 40 und eine 41 Reihe mit fünf Leitflächen 40 ausgebildet. Dabei sind zehn Reihen 41 auf einer gedachten Linie, welche parallel zur Längsachse L angeordnet ist, ausgebildet und 6 Reihen 41 auf einer gedachten Linie, welche parallel zur Breitachse B angeordnet ist, ausgebildet. Durch die Anordnung der Leitflächen 40 wird dem Leiterplattenlagenaufbau nochmals mehr Stabilität gegeben. Die Leitflächen 40 können allerdings auch versetzt zueinander angeordnet sein, wodurch Bereiche, die kritisch hinsichtlich der Stabilität des Lagenaufbaus sind, gezielt verstärkt werden.

Die Anordnung von Leitflächen 40 ist in Gruppen einordbar. Auf der Leiterplatte 20 kann mindestens eine Gruppe 42 angeordnet sein. Eine Gruppe 42 weist mindestens zwei zueinander überlappende, vorzugsweise vollständig überlappende, Reihen 41 auf. Eine Gruppe 42 muss dabei nicht jedes Mitglied einer Reihe 41 verwenden, um als Gruppe 42 zu gelten. Es müssen jedoch mindestens zwei Mitglieder einer Reihe 41 bei der Bildung einer Gruppe 42 involviert sein. Die Mitglieder der Gruppe 42 müssen dabei nicht nebeneinander liegen.

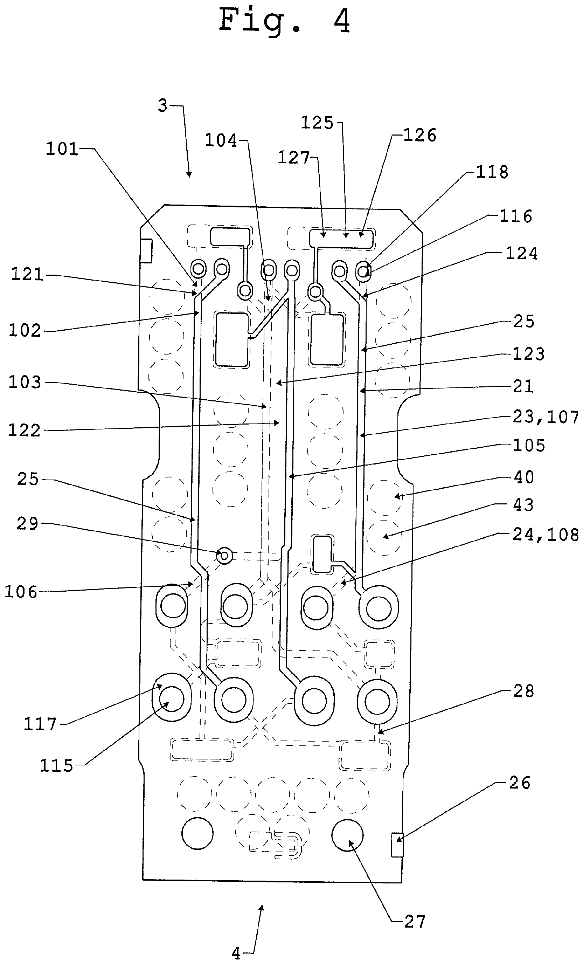

In Fig. 4 ist die oberste Leiterplattenlage 26 durch Vollstriche und die darunterliegenden Leiterplattenlagen 26 durch gestrichelte Linien angedeutet. Die Kompensationseinheiten 125 sind gut zu erkennen, wobei die Platten 127 der meisten Plattenkondensatoren 126 vollständig überlappend zueinander angeordnet sind. Im Bereich der Hinterseite 4 sind die beiden Löcher 27 angeordnet, durch welche die Stifte 66 des Trägerelements 60 geführt werden und damit eine Verschiebung der Leiterplatte 20 innerhalb einer Ebene verhindern. Zudem sind die zweiten Kontaktpads 118 deutlich kleiner ausgebildet als die ersten Kontaktpads 117. Beide Kontaktpads 117, 118 sind ovalförmig ausgebildet. Die Leiterbahnen eins 101 und zwei 102 der ersten differentiellen Leitung 121 sind abschnittsweise vollständig überlappend zueinander angeordnet. Dasselbe gilt für die vierte differentielle Leitung 124. Zudem laufen die Leiterbahnen fünf 105 und sechs 106 abschnittsweise übereinander sowie die Leiterbahnen drei 103 und vier 104.

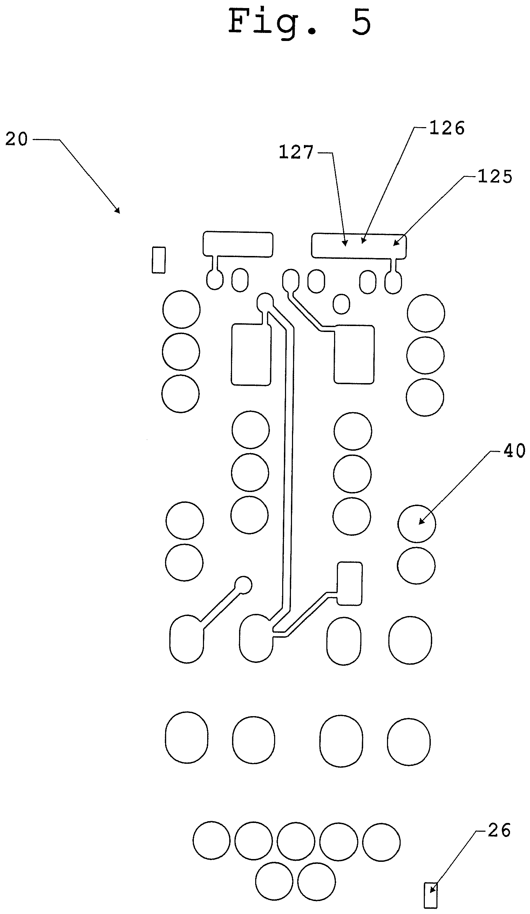

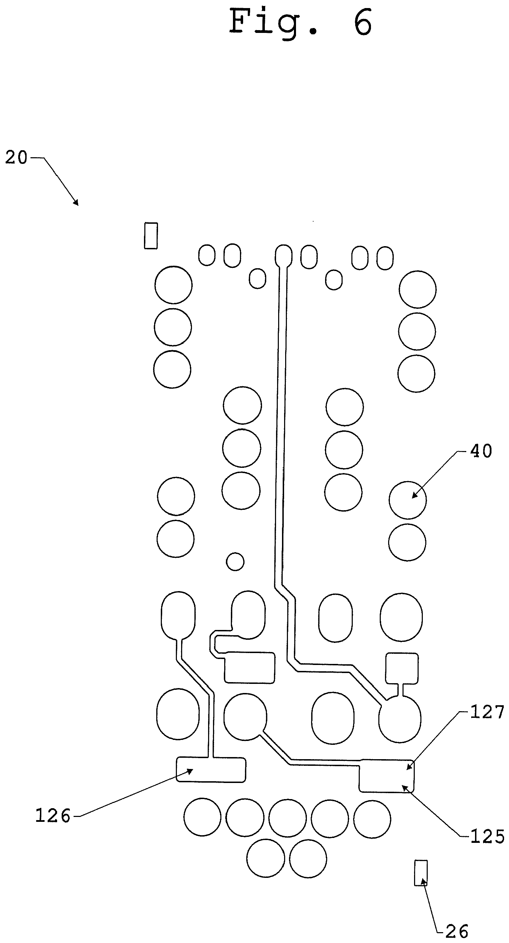

In Fig. 5 und 6 sind die inneren Leiterplattenlagen 26 aufgezeigt. Insbesondere sind die Leitflächen 40 gut erkennbar. Die Leitflächen 40 können wie dargestellt rund sein, aber auch oval oder vieleckig, insbesondere viereckig oder die Form eines Parallelogramms oder eines Trapezes aufweisen. Die Leitflächen 40 sind derart ausgestaltet, dass möglichst viele möglichst große Leitflächen auf der Leiterplatte 20 angeordnet werden können. Hierfür müssen sich die Leitflächen 40 an das Schaltungsdesign anpassen und dementsprechend ihre Form angleichen.

Die Platten 127 eines Plattenkondensators 126 sind in dieser Ausführung nie auf benachbarten inneren Leiterplattenlagen 26 angeordnet. Die Platten 127 eines Plattenkondensators 126 können allerdings auch auf benachbarten inneren Leiterplattenlagen 26 angeordnet sein.

### Bezugszeichenliste

- 1: Elektrischer Verbinder
- 2: Steckbuchse
- 3: Vorderseite
- 4: Hinterseite
- 5: Oberseite
- 6: Unterseite

- 10: Gehäuse
- 11: Gehäuseoberteil
- 12: Dach
- 13: Vordach
- 14: Seitenwand
- 15: Nase
- 16: Fixierelement

- 20: Leiterplatte
- 21: Leiterbahn
- 22: Differentielle Leitung
- 23: Erste Leiterbahn
- 24: Zweite Leiterbahn
- 25: Leitungspfad
- 26: Leiterplattenlage
- 27: Loch
- 28: Stichleitung
- 29: Via

- 30: Erste Kontaktelemente
- 31: Schneidklemme
- 32: Schneidklemmenfläche
- 33: Nase
- 34: Loch
- 35: Zweite Kontaktelemente
- 36: Steckkontakt

- 40: Leitfläche
- 41: Reihe
- 42: Gruppe
- 43: Leitflächenmittelpunkt

- 50: Ladestück
- 51: Erste Schenkel
- 52: Durchgangslöcher
- 53: Zweite Schenkel
- 54: Führungen
- 55: Aushöhlungen

- 60: Trägerelement
- 61: Aussparungen
- 62: Erhöhung
- 63: Außenfläche
- 64: Erste Einkerbung
- 65: Zweite Einkerbung
- 66: Stifte

- 70: Abdeckung
- 71: Aushöhlung
- 72: Einbuchtung
- 73: Schiene
- 74: Aushöhlung

- 80: Schirmteil
- 81: Grundplatte
- 82: Erste Außenfläche
- 83: Zweite Außenfläche
- 84: Überhang
- 85: Erste Rastnase
- 86: Zweite Rastnase
- 87: Haltenase
- 88: Befestigungselement

- 90: Gehäuseunterteil
- 91: Boden
- 92: Seitenfläche
- 93: Freifläche
- 94: Dach
- 95: Ausbuchtung
- 96: Erste Ausbuchtung
- 97: Zweite Ausbuchtung
- 98: Dritte Ausbuchtung
- 99: Ausstülpung

- 101: Leiterbahn eins
- 102: Leiterbahn zwei
- 103: Leiterbahn drei
- 104: Leiterbahn vier
- 105: Leiterbahn fünf
- 106: Leiterbahn sechs
- 107: Leiterbahn sieben
- 108: Leiterbahn acht

- 110: Fuß
- 111: Fuß
- 112: Öffnung
- 115: Erste Durchgangsöffnung
- 116: Zweite Durchgangsöffnung
- 117: Erstes Kontaktpad
- 118: Zweites Kontaktpad

- 121: Erste differentielle Leitung
- 122: Zweite differentielle Leitung
- 123: Dritte differentielle Leitung
- 124: Vierte differentielle Leitung
- 125: Kompensationseinheit
- 126: Plattenkondensator
- 127: Platten

- L: Längsachse
- B: Breitachse
- Q: Querachse

## Patentansprüche

1. Elektrischer Verbinder (1) für ein Datenkabel mit folgenden Merkmalen:
- ein Gehäuse (10),
- eine zumindest teilweise im Gehäuse (10) angeordnete Leiterplatte (20), wobei die Leiterplatte (20) als mehrlagige Leiterplatte ausgebildet ist.
- erste Kontaktelemente (30) und zweite Kontaktelemente (35), wobei diese jeweils über eine Leiterbahn (21) miteinander verbunden sind und die Leiterbahn (21) einen Leitungspfad (25) und Kontaktpads (117, 118) aufweist.
**gekennzeichnet durch** die weiteren Merkmale:
- die Leiterplatte (20) weist elektrisch isolierte Leitflächen (40) auf,
- die Leitflächen (40) sind auf mindestens einer inneren Leiterplattenlage (26) angeordnet,
- eine innere Leiterplattenlage (26) weist mindestens drei Leitflächen (40) auf, und
- die Leitfläche (40) ist höchstens zu einem Leitungspfad (25) überlappend angeordnet.

2. Elektrischer Verbinder (1) nach Anspruch 1, **dadurch gekennzeichnet, dass** jeweils zwei Leiterbahnen (21) eine differentielle Leitung (22) ausbilden, wobei eine Leiterbahn (21) ein erstes (117) und zweites Kontaktpad (118) aufweist, welche über einen Leitungspfad (25) miteinander verbunden sind.

3. Elektrischer Verbinder (1) nach Anspruch 1 oder 2, **dadurch gekennzeichnet, dass** auf einer inneren Leiterplattenlage (26) mehr oder gleich viele Leitflächen (40) ausgebildet sind als auf einer anderen inneren Leiterplattenlage (26).

4. Elektrischer Verbinder (1) nach einem der vorherigen Ansprüche, **dadurch gekennzeichnet, dass** die Fläche der Leitfläche (40) maximal annähernd zwischen 0,5 % bis 100 % der Fläche der Leiterplattenlage (26) ausmacht.

5. Elektrischer Verbinder (1) nach einem der vorherigen Ansprüche, **dadurch gekennzeichnet, dass** die Gesamtfläche aller Leitflächen (40) mindestens annähernd zwischen 2 % bis 125 % der Fläche der Leiterplattenlage (26) ausmacht.

6. Elektrischer Verbinder (1) nach einem der vorherigen Ansprüche, **dadurch gekennzeichnet, dass** die Gesamtfläche aller Leitflächen (40) auf einer Leiterplattenlage (26) mindestens annähernd zwischen 2 % bis 100 % der Fläche der Leiterplattenlage (26) ausmacht.

7. Elektrischer Verbinder (1) nach einem der vorherigen Ansprüche **dadurch gekennzeichnet, dass** die Leitfläche (40) die Form eines Ovals oder eines Kreises oder eines Vielecks, vorzugsweise eines Vierecks oder eines Trapezes oder eines Kreises oder eines Parallelogramms, aufweist.

8. Elektrischer Verbinder (1) nach einem der vorherigen Ansprüche, **dadurch gekennzeichnet, dass** vorzugsweise mehr als fünf, besonders bevorzugt mehr als zehn, ganz besonders bevorzugt mehr als zwanzig, im äußersten bevorzugt mehr als fünfzig, im aller äußersten bevorzugt mehr als einhundert Leitflächen (40) auf der Leiterplatte (20) angeordnet sind.

9. Elektrischer Verbinder (1) nach einem der vorherigen Ansprüche, **dadurch gekennzeichnet, dass** zumindest zwei Leitflächen (40) auf unterschiedlichen Leiterplattenlagen (26) vollständig überlappend zueinander angeordnet sind.

10. Elektrischer Verbinder (1) nach einem der vorherigen Ansprüche, **dadurch gekennzeichnet, dass** keine Leitfläche (40) zu einem Leitungspfad (25) überlappend angeordnet ist.

11. Elektrischer Verbinder (1) nach einem der vorherigen Ansprüche, **dadurch gekennzeichnet, dass** die Leitflächen (40) in mindestens einer Reihe (41) angeordnet sind, wobei eine Reihe (41) zwei Leitflächen (40) aufweist, wobei die Leitflächenmittelpunkte (43) der Leitflächen (40) einer Reihe (41) auf einer gedachten Linie liegen, wobei die Linie parallel zu einer Längsachse (L) des elektrischen Verbinders (1) oder zu einer Breitachse (B) des elektrischen Verbinders (1) angeordnet ist.

12. Elektrischer Verbinder (1) nach einem der vorherigen Ansprüche, **dadurch gekennzeichnet, dass** die Leitflächen (40) in mindestens einer Gruppe (42) angeordnet sind, wobei sich eine Gruppe (42) aus zwei zueinander überlappenden Reihen (41), vorzugsweise vollständig überlappende Reihen (41), zusammensetzt.

13. Elektrischer Verbinder (1) nach einem der vorherigen Ansprüche, **dadurch gekennzeichnet, dass** die Leitfläche (40) aus einem elektrisch leitenden Material, vorzugsweise aus Kupfer oder Aluminium, ausgebildet ist.

14. Elektrischer Verbinder (1) nach einem der vorherigen Ansprüche, **dadurch gekennzeichnet, dass** der elektrische Verbinder (1) als Steckbuchse (2) ausgebildet ist.
